# EUROPÄISCHE PATENTANMELDUNG

(11) **EP 1 515 596 A2**
(43) Veröffentlichungstag der Anmeldung: **16.03.2005**
(21) Anmeldenummer: 04016398.2
(22) Anmeldetag: 13.07.2004
(51) Int. Cl.: H05K 7/02, H01G 2/06

(54) **Bauelemente-Halter**

(30) Priorität: 15.09.2003 DE 10342483
(71) Anmelder: ROBERT BOSCH GMBH, 70442 Stuttgart (DE)
(72) Erfinder: Uhland, Thomas, 74397 Pfaffenhofen-Weiler (DE); Schmidt, Dirk, 70771 Leinfelden-Echterdingen (DE); Degirmenci, Ibrahim, 71665 Vaihingen (DE); Distler, Frank, 97776 Münster (DE)

(57) **Zusammenfassung**

Bauelemente-Halter (1) zur Aufnahme eines elektrischen Bauelementes (200) mit an einer Unterseite (60) angeordneten Stiften (30), die einstückig mit dem Rahmen (10) verbunden sind und die mit Ausnehmungen eines Schaltungsträgers korrespondieren, wobei an der Unterseite (60) des Rahmens (10) Abstandselemente (40) einstückig mit dem Rahmen (10) verbunden sind.

## Beschreibung

### Stand der Technik

Die Erfindung geht aus von einem Bauelemente-Halter nach der Gattung des unabhängigen Anspruchs. Aus der JP 09260181 A ist bereits ein röhrenförmiger Bauelemente-Halter zur Aufnahme zylindrischer Bauelemente bekannt. Der röhrenförmige Halter ist auf beiden Seiten offen ausgeführt. Auf der einen Seite der Röhre sind Stützfüße für die Montage auf einer Leiterplatte angeordnet. Das Bauelement wird über federnde Blechstreifen in der Röhre gehalten.

### Vorteile der Erfindung

Der erfindungsgemäße Bauelemente-Halter mit den Merkmalen des unabhängigen Anspruchs hat demgegenüber den Vorteil, dass der Rahmen des Bauelemente-Halters bei einer Anordnung auf einem Schaltungsträger nicht mit dem gesamten Umfang der Unterseite des Rahmens auf dem Schaltungsträger aufliegt, sondern nur auf den Abstandselementen aufliegt. Der durch die Abstandselemente erzeugte Spalt zwischen Rahmen und Schaltungsträger kann vorteilhaft für die Anordnung weiterer Leiterbahnen oder Bauelemente auf der Leiterplatte genutzt werden.

Gemäß einer bevorzugten Weiterbildung ist an der Unterseite des Bauelemente-Halters eine Positionsplatte angeordnet mit wenigstens einer Öffnung zur Durchführung wenigstens eines Anschlusskontaktes eines Bauelementes. So können in vorteilhafter Weise beispielsweise die Anschlusskontakte eines bedrahteten Bauelements über die Öffnungen der Positionsplatte so ausgerichtet werden, dass die Anschlusskontakte bei einer Montage des Bauelemente-Halters direkt in Öffnungen eines Schaltungsträgers eingebracht werden können.

Durch die in den Unteransprüchen aufgeführten Maßnahmen sind vorteilhafte Weiterbildungen und Verbesserungen der in den unabhängigen Ansprüchen angegebenen Bauelemente-Halter möglich.

Gemäß einer bevorzugten Weiterbildung werden die Abstandselemente zumindest teilweise im Bereich der Stifte angeordnet, wobei in diesem Bereich der Rahmen, die Abstandselemente und die Stifte einstückig miteinander verbunden sind. So können in einfacher und vorteilhafter Weise am selben Ort über die Stifte der Rahmen mechanisch befestigt und über die Abstandelemente ein Spalt zwischen Rahmen und Schaltungsträger eingestellt werden.

Gemäß einer weiteren bevorzugten Ausführungsform weist die Positionsplatte eine erste und eine zweite Öffnung zur Durchführung von Anschlusskontakte des Bauelementes auf, wobei die zweite Öffnung einen größeren Querschnitt als die erste Öffnung hat. Dies ist insbesondere dann von Vorteil wenn Bauelemente mit einer bevorzugten Einbaulage durch den Bauelemente-Halter eingefasst werden sollen. Bei Elektrolyt-Kondensatoren können beispielsweise die Polaritäten durch unterschiedlich dicke Anschlusskontakte markiert sein. Die erfindungsgemäße Positionsplatte des Bauelemente-Halters erlaubt nun aufgrund der unterschiedlichen Querschnitte der Öffnungen in vorteilhafter Weise nur eine bestimmte Einbaulage, sodass bei der Montage ein fehlerhafter Einbau vermieden wird.

Gemäß einer weiteren bevorzugten Ausführungsform ist das Bauelement bereits innerhalb des Rahmens angeordnet, wobei wenigstens ein Anschlusskontakt durch eine Öffnung der Positionsplatte geführt ist, wobei Bauelemente-Halter und Bauelement zusammen in vorteilhafter Weise eine gemeinsame elektronische Baugruppe bilden, die als Ganzes auf einem Schaltungsträger bestückt werden kann.

### Zeichnungen

Ausführungsbeispiele der Erfindung sind in den Zeichnungen dargestellt und in der nachfolgenden Beschreibung näher erläutert.

Es zeigen:
- Figur 1: einen erfindungsgemäßen Bauelemente-Halter;
- Figur 2: eine erfindungsgemäße Positionsplatte;
- Figur 3: eine Explosionsdarstellung eines erfindungsgemäßen Bauelemente-Halters mit Bauelement;
- Figur 4: eine erfindungsgemäße elektronische Baugruppe.

### Beschreibung der Ausführungsbeispiele

In den Figuren bezeichnen gleichen Bezugszeichen gleiche oder funktionsgleiche Bestandteile.

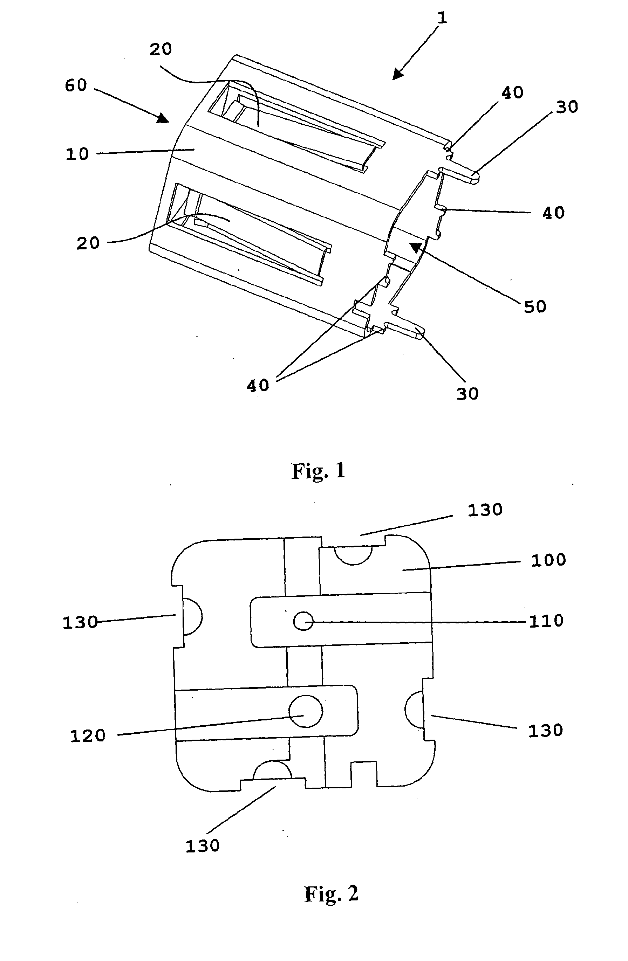

Figur 1 zeigt einen erfindungsgemäßen Bauelemente-Halter 1 in perspektivischer Ansicht. Der Bauelemente-Halter 1 wird gebildet aus einem an einer Ober- und Unterseite 60, 50 offenen Rahmen 10. An der Unterseite des Rahmens 10 befinden sich an jeder Rahmenkante jeweils ein Abstandselement 40. An zwei gegenüberliegenden Rahmenkanten sind an den Abstandselementen 40 Stifte 30 angeordnet. Die Stifte 30, die Abstandselemente 40 und der Rahmen 10 sind einstückig miteinander verbunden. An den geschlossenen Seiten des Rahmens 10 sind Einschnitte vorgesehen, die aus dem Rahmenmaterial jeweils eine Zunge frei legen, die jeweils als federndes Element 20 zur Fixierung eines Bauelementes 200 im Inneren des Rahmens 10 dienen.

Die Abstandselemente 40 dienen dazu einen Freiraum zwischen Schaltungsträger und Bauelemente-Halter 1 herzustellen. Der so gewonnene Freiraum kann beispielsweise dazu genutzt werden, weitere Leiterbahnen oder Bauelemente unterhalb der Rahmenkanten anzuordnen, wie dies bei einem flach aufliegenden Rahmen nicht möglich ist. Des weiteren hat sich gezeigt, dass Vibrationen und/oder Schüttelbelastungen, die auf den Schaltungsträger einwirken sich durch Abstandselemente weniger stark auf den Rahmen 10 und demzufolge auch auf das Bauelement 200 übertragen.

Die Stifte 30 sind so angeordnet und ausgeführt, dass sie in Ausnehmungen eines Schaltungsträgers eingreifen können und dort mechanisch und eventuell auch elektrisch mit dem Schaltungsträger verbindbar sind.

Der Bauelemente-Halter 1 ist einstückig aus einem Material, beispielsweise einem Blech oder einem Kunststoff gefertigt. Ein aus Kunststoff gefertigter Bauelemente-Halter 1 hat den Vorteil, dass er einfach beispielsweise aus Spritzguss zu fertigen ist und darüber hinaus auch an Positionen auf einem Schaltungsträger angeordnet werden kann, an denen metallische Bauelemente-Halter kritisch wären. Ein metallischer Bauelemente-Halter hat wiederum den Vorteil, dass er direkt mit dem Schaltungsträger verlötet werden kann und so in einfacher Art und Weise ein inniger Verbund mit dem Schaltungsträger herstellbar ist. Darüber hinaus können an einen metallische Bauelemente-Halter 1 Potenziale und insbesondere Masse-Potenziale angelegt werden und so beispielsweise zur Verbesserung der elektromagnetische Verträglichkeit beitragen.

In einer weiteren Variante kann der Bauelemente-Halter 1 an der Oberseite 60 geschlossen ausgeführt sein.

In einem weiteren bevorzugten Ausführungsbeispiel ist an der Unterseite 50 des in Figur 1 beschriebenen Bauelemente-Halters 1 eine Positionsplatte 100 gemäß Figur 2 angeordnet. Die Positionsplatte 100 schließt die Unterseite 60 des Rahmens 10 bündig ab. Im Bereich der Abstandselemente 40 des Rahmens 10 sind an der Positionsplatte 100 Ausnehmungen 130 angeordnet. Die Dicke der Positionsplatte 100 ist so gewählt, dass die Unterseite der Abstandselemente 40 bündig mit der Unterseite der Positionsplatte 100 abschließt. Zur Durchführung von Anschlusskontakten 210, 220 eines Bauelementes 200 sind in der Positionsplatte 100 Öffnungen 110 und 120 vorgesehen, wobei die Öffnung 120 einen größeren Querschnitt als die Öffnung 110 aufweist.

Die Positionsplatte kann beispielsweise vollständig aus Kunststoff gefertigt sein. In einer anderen Variante, ist jeweils im Bereich einer Öffnung ein metallischer Leiter angeordnet, über den die jeweiligen Anschlusskontakte 210, 220 des Bauelementes 200 kontaktiert werden können und die elektrischen Kontaktierung weiter nach außen geführt werden kann. In einer weiteren Variante ist die Positionsplatte 100 metallisch und nur in den Bereichen der Öffnungen 110, 120 elektrisch isolierend ausgeführt.

Darüber hinaus kann die Positionsplatte 100 dreidimensional strukturiert sein, um beispielsweise durch Bildung von stiegen und Vertiefungen weitere Stabilität zu erhalten. Des Weiteren kann die Positionsplatte 100 an die Geometrie des Bauelementes 200 angepasst sein.

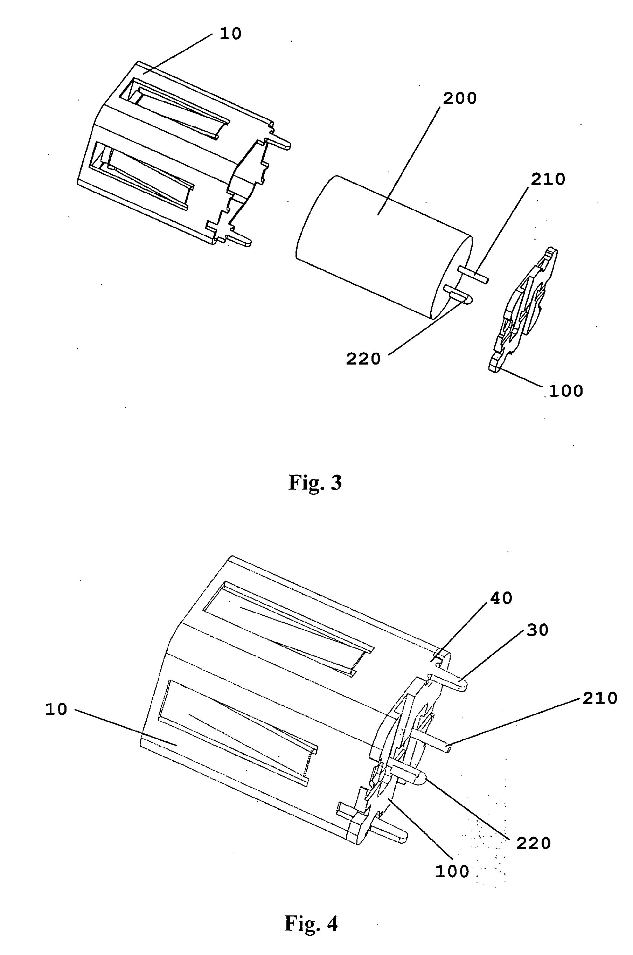

Figur 3 zeigt in Explosionsdarstellung eine erfindungsgemäße elektronische Baugruppe gemäß Figur 4. Das Bauelement 200 wird beispielsweise von der Unterseite 60 in den Rahmen 10 eingebracht, wobei die Anschlusskontakte 210, 220 durch die Öffnungen 110, 120 der Positionsplatte 100 geführt sind und wobei die Positionsplatte 100 die Unterseite 60 des Rahmens 10 verschließt.

Die Figur 4 zeigt ein Ausführungsbeispiel eines Bauelemente-Halters 1 in einem zusammengebaut Zustand. In dieser Ausführungsform kann der erfindungsgemäße Bauelemente-Halter 1 als elektronische Baugruppe beispielsweise in einem automatischen Bestückungsprozess eingebracht werden und wie ein übliches Bauelement auf einem Schaltungsträger bestückt werden. Ein derartiges Vorgehen hat insbesondere den Vorteil, dass ein bedrahtetes Bauelement durch die Einbringen in den erfindungsgemäßen Bauelemente-Halter einfacher zu handhaben ist, da die flexiblen Anschlusskontakte 210, 220 eines bedrahteten Bauelementes durch die Öffnungen 110, 120 der Positionsplatte 100 geführt werden und hierdurch die Anschlusskontakte 210, 220 sicherer und stabiler zuführen sind. Eine derartig gehaltenes bedrahtetes Bauelement kann so in einfacher und vorteilhafter Weise ohne zusätzliche Positionierungshilfen auf einem Schaltungsträger angeordnet werden.

Darüber hinaus können, wie in Figur 3 und 4 gezeigt, bestimmte Anschlusskontakte 210 eines bedrahteten Bauelementes durch Vergrößerung des Querschnittes markiert sein. Dies kann beispielsweise durch geeignetes Umbiegen eines Anschlusskontaktes erfolgen oder aber der Anschlusskontakte wird von vorneherein dicker ausgeführt. Dies erlaubt es, beispielsweise verschiedene Polaritäten eines Elektrolyt-Kondensator zu kennzeichnen, sodass bei Verwendung eines erfindungsgemäßen Bauelemente-Halters 1 mit Positionsplatte 100 Verpolungen vermeidbar sind.

## Patentansprüche

1. Bauelemente-Halter (1) zur Aufnahme eines elektrischen Bauelementes (200)
- mit an einer Unterseite (60) angeordneten Stiften (30), die einstückig mit dem Rahmen (10) verbunden sind und die mit Ausnehmungen eines Schaltungsträgers korrespondieren,
- **dadurch gekennzeichnet, dass** an der Unterseite (60) des Rahmens (10) Abstandselemente (40) einstückig mit dem Rahmen (10) verbunden sind.

2. Bauelemente-Halter (1) nach Anspruch 1, **dadurch gekennzeichnet, dass** die Abstandselemente (40) zumindest teilweise im Bereich der Stifte (30) angeordnet sind, wobei in diesem Bereich der Rahmen (10), die Abstandselemente (40) und die Stifte (30) einstückig miteinander verbunden sind.

3. Bauelemente-Halter (1) zur Aufnahme eines elektrischen Bauelementes (200)
- mit an einer Unterseite (60) angeordneten Stiften (30), die einstückig mit dem Rahmen (10) verbunden sind und die mit Ausnehmungen eines Schaltungsträgers korrespondieren,
- **dadurch gekennzeichnet, dass** an der Unterseite (60) des Rahmens (10) Abstandselemente (40) einstückig mit dem Rahmen (10) verbunden sind,
- und dass an der Unterseite (60) des Rahmens (10) eine Positionsplatte (100) angeordnet ist, wobei die Positionsplatte (100) wenigstens eine Öffnung (110) zur Durchführung wenigstens eines Anschlusskontaktes (210) des Bauelementes (200) aufweist.

4. Bauelemente-Halter (1) nach Anspruch 3, **dadurch gekennzeichnet, dass** die Abstandselemente (40) zumindest teilweise im Bereich der Stifte (30) angeordnet sind, wobei in diesem Bereich der Rahmen (10), die Abstandselemente (40) und die Stifte (30) einstückig miteinander verbunden sind.

5. Bauelemente-Halter (1) nach wenigstens einen der Ansprüche 3 bis 4, **dadurch gekennzeichnet, dass** die Positionsplatte (100) eine erste Öffnung (110) und eine zweite Öffnung (120) zur Durchführung von Anschlusskontakten (210, 220) eines Bauelementes (200) aufweist, wobei die zweite Öffnung (120) einen größeren Querschnitt als die erste Öffnung (110) aufweist.

6. Elektronische Baugruppe mit einem Bauelemente-Träger nach Anspruch 3, 4 oder 5, **dadurch gekennzeichnet, dass** ein Bauelement (200) innerhalb des Rahmens (10) angeordnet ist und der wenigstens eine Anschlusskontakt (210, 220) des Bauelementes (200) durch die wenigstens einen Öffnung (110, 120) der Positionsplatte (100) geführt ist.
